# EUROPEAN PATENT SPECIFICATION

(11) **EP 2 141 130 B1**
(45) Date of publication and mention of the grant of the patent: **28.09.2011**
(21) Application number: 08012145.2
(22) Date of filing: 04.07.2008
(51) Int. Cl.: C03B 19/09, C30B 15/10

(54) **Method for producing vitreous silica crucible**
Verfahren zur Herstellung eines Quarzglastiegels
Procédé de production de creuset en verre de silice

(43) Date of publication of application: 06.01.2010
(73) Proprietor: Japan Super Quartz Corporation, Akita-shi, Akita-ken 010-0065 (JP)
(72) Inventor: Kishi, Hiroshi c/o Japan Super Quartz Corporation, Akita-ken (JP); Kanda, Minoru c/o Japan Super Quartz Corporation, Akita-ken (JP)
(74) Representative: Ziebig, Marlene

(56) References cited:
- EP-A- 0 319 031
- JP-A- 4 119 986
- JP-A- 10 025 184
- US-A- 4 530 378
- US-A1- 2002 170 316

## Description

### BACKGROUND OF THE INVENTION

### Field of the Invention

The present invention relates to a method for producing a vitreous silica crucible having excellent formability and resulting in fewer internal bubbles.

### Description of Related Art

Single crystal silicon is mainly produced by a CZ method. This method is a method for producing single crystal silicon by dipping a seed crystal into a molten silicon liquid contained in a silica crucible at a high temperature, and then slowly pulling up the seed crystal. The method utilizes a vitreous silica crucible of high purity for storing the molten silicon liquid.

The vitreous silica crucibles used for the pulling up of single crystal silicon are mainly produced according to an arc melting method. This method includes producing a vitreous silica crucible by depositing quartz powder to a certain thickness on the inner surface of a rotating mold made of carbon to thus form a quartz powder molded product, as well as beating and melting the quartz powder by means of are discharge of an electrode installed on the inner upper side of the mold to vitrify the quartz powder (rotating mold method).

In connection to the above-described method, there is known a method of melting the quartz powder by deaerating the quartz powder molded product under reduced pressure through suction from the mold side, in order to eliminate bubbles inside the glass layer (Patent Document 1 and Patent Document 2). In this melting process, deaerating the quartz powder molded product under reduced pressure (this is referred to as vacuum suction) necessitates increasing the degree of vacuum inside the quartz powder molded product by sealing the inner side of the quartz powder molded product by melting the inner surface uniformly and thinly to form a thin glass layer on the surface.

With regard to the above production method for producing a glass crucible by melting a quartz powder molded product, conventionally, a method of installing an arc electrode along the center line of a rotating mold, and uniformly heating a quartz powder molded product lining the inside of a mold, is generally used. However, the rim edge on the upper side of the quartz powder molded product formed on the inner side of the mold has lower heat retaining properties than the curved portion or bottom part of the molded product, and thus the melting rate of the rim edge is slower. Also, since a thin glass layer is not sufficiently formed on the surface of the rim edge, the degree of vacuum inside the quartz powder molded product is not increased, and a crucible having fewer internal bubbles in the glass layer cannot be obtained. On the other hand, if the rim edge is melted under an increased calorific value of arc melting so as to supplement insufficient melting of the rim edge, there is a problem that the curved portion or the bottom part is excessively heated and melts, causing the shape of the quartz powder molded product to become susceptible to disintegration. A method where electrodes can be positioned eccentrically is known from US 2002/0170316.

[Patent Document 1] Japanese Unexamined Patent Application No. 06-191986 [Patent Document 2] Japanese Unexamined Patent Application No. 10-025184

### SUMMARY OF THE INVENTION

- The present invention is intended to address the above-described problems in the conventional production methods, and provides a method for producing a vitreous silica crucible having excellent shape formability as well as having fewer internal bubbles, in which the rim edge of the crucible is sufficiently sealed on the inner side while the curved portion and the bottom part are not heated excessively, and the degree of vacuum in the quartz powder molded product is high

The invention relates to a method for producing a vitreous silica crucible as defined in claim 1, by which the problems are solved on the basis of the following constitution.

In the production method of the invention, since the electrode is moved sideways with respect to the mold center line upon the initiation of arc melting or during the arc melting, and arc melting is performed, at an eccentric position, excessive heating of the lower side of side wall, the curved portion and the bottom part can be suppressed, by bringing the electrode near to the crucible rim edge and performing the arc melting, the rim edge can be heated and melted sufficiently, and an inner side seal of a thin glass layer can be uniformly formed over the whole crucible inner surface. Accordingly, a vitreous silica crucible having fewer internal bubbles can be obtained.

In the production method, since total heating in which arc melting is performed with the electrode positioned along the mold center line and local heating in which arc melting is performed with the electrode positioned at an eccentric position outside the mold center line are performed, and the arc melting is controlled such that the total heating time is limited to 60% or less of the total arc melting time, the rim edge is sufficiently heated and melted. At the same time, excessive heating of the portion extending from the lower part of the crucible side wall to the curved portion and the bottom part is suppressed. Thus, the glass viscosity of this portion is not decreased to a large extent, there is no tipping of glass from the lower part of side wall or inclination of glass from the bottom part, and an extreme increase in the thickness at the corner part is prevented. Thus, a crucible having excellent formability can be obtained.

In the production method of the invention, for example, in the local heating, the heating and melting is performed while the distance L2 from the center of the electrode tip to the heated site of the quartz powder molded product is maintained at 5 to 80% of the distance L1 from the mold center line to the heated site; in the arc melting using three-phase alternating current electrodes, the area of a circumscribed circle contacting each of the electrode tips is limited to 710 cm² or less in planar view, and the entire area of the circumscribed circle is arc heated; and arc melting is performed with the distance between the electrode centers limited to 15 cm or less. Thereby, there can be obtained a vitreous silica crucible in which, for example, a curvature W2 of the inner side of the curved portion is 0.8 to 1.2-fold the curvature of the outer side of the curved portion W1 and five or fewer internal bubbles having a size of 0.5 mm or larger are present in the entire curved portion within a depth range of 1.0 mm from the inner surface area of the whole crucible. Arc melting is not limited to a three-phase alternating current three-electrode structure. For example, a two-phase alternating current four-electrode structure, a three-phase alternating current six-electrode structure, a three-phase alternating nine-electrode structure, a four-phase alternating eight-electrode structure and the like can be adopted.

### BRIEF DESCRIPTION OF THE DRAWINGS

FIG. 1 is a conceptual diagram illustrating the production of a vitreous silica crucible according to the rotating mold method.
FIG. 2 is a conceptual diagram showing the curvature of the curved portion of a crucible.
FIG 3 is a conceptual diagram showing electrodes and a circumscribed circle.
FIG. 4 is an explanatory diagram showing the curvature of the curved portion of a crucible.
FIG. 5 is a sectional diagram showing an embodiment of an apparatus for manufacturing a vitreous silica member.
FIG. 6 is a sectional diagram showing an embodiment of a vitreous silica crucible.
FIG. 7 is a sectional diagram showing the other embodiment of a vitreous silica crucible .

### REFERENCE NUMERALS

- 10: Mold
- 11: Quartz powder molded product
- 12: Vent hole
- 13: Electrode
- 15: Upper rim edge
- 16: Side wall part
- 17: Curved portion
- 18: Bottom part
- L: Mold center line
- L1: Distance from the heated site to the mold center line
- L2: Distance from the heated site to the electrode tip
- L3: Distance between electrode centers
- W1: Curvature of the outer side of the curved portion
- W2: Curvature of the inner side of the curved portion
- S: Circumscribed circle
- R: Curvature measurement range

### DETAILED DESCRIPTION OF THE INVENTION

Hereinafter, the present invention will be described in detail with reference to exemplary embodiments.

The production method of the invention is a method for producing a vitreous silica crucible, comprising arc melting a quartz powder molded product loaded in a rotating mold while performing vacuum suction, wherein the electrode is moved relatively sideways with respect to the mold center line upon the initiation of arc melting or during the arc melting, and the arc melting is performed at an eccentric position.

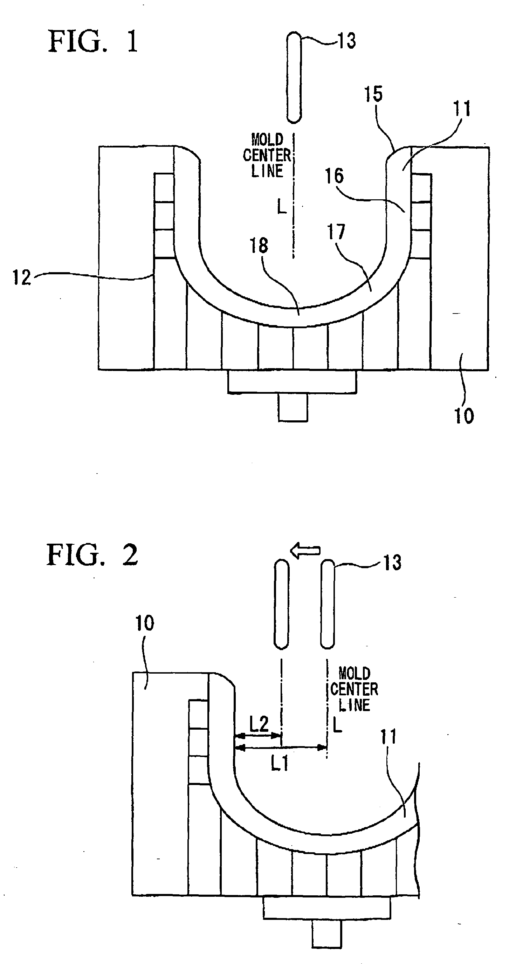

FIG. 1 schematically illustrates the method for producing a vitreous silica crucible by arc melting a quartz powder molded product loaded in a rotating mold. As shown in the drawing, quartz powder is loaded to a predetermined thickness on the inner side of a rotating mold 10, and thus a quartz powder molded product 11 is formed. The mold 10 is provided with a vent hole 12 for vacuum suction, and this vent hole 12 is open to the inner side of the mold. An electrode 13 for arc heating is provided along the center line L of the mold 10, and the quartz powder molded product 11 is arc melted using the electrode 13, while performing vacuum suction, to thus melt the quartz powder and to produce a glass crucible.

In an apparatus for performing the production method of the invention, it is preferable that either the mold 10 or the electrode 13 is provided with a vertically moving means (not depicted), and either the mold 10 or the electrode 13 is provided with a laterally moving means (not depicted). In the production method of the invention, as shown in FIG. 2, either the rotating mold 10 or the arc electrode 13 is moved laterally, and thereby the electrode 13 is moved relative sideways with respect to the mold center line L, and arc melting is performed at an eccentric position.

During the arc melting, since the mold 10 is rotating, even if arc melting is performed with the electrode 13 brought near to one side of the rim edge 15b, the entirety of the rim edge 15 is arc melted intermittently continuously at a position closer to the electrode 13, and thus the entire rim edge is uniformly heated and melted.

In the production method of the invention, the total heating time is controlled to 60% or less of the total arc melting time, by performing total heating in which arc melting is performed with the electrode 13 positioned along the mold center line, as well as local heating in which arc melting is performed with the electrode 13 positioned at an eccentric position outside the mold center line.

It is preferable that the start of the eccentric positioning time be in the range of 5 to 30%, counting from the start of the total arc melting time and the end of the eccentric positioning time be in the range of 40 to 60%, counting from the start of the total arc melting time.

In general, since the rim edge 15 of the quartz powder molded product 11 is in contact with the air at the side surface and the upper surface, the heat retaining property of the rim edge 15 is lower than that of the side wall part 16, curved portion 17 and bottom part 18. Because of this, when total heating based on the rim edge is performed through the total arc melting time, the portion extending from the lower part of the side wall part 16 to the curved portion 17 and the bottom part 18 is heated to a temperature exceeding an appropriate temperature, and because of this excessive heating, the glass viscosity of the portion is largely decreased. As a result, there occurs tipping of molten glass from the lower part of the side wall due to gravity, or the inclination of glass from the bottom part due to the centrifugal force generated by mold rotation, and thus there is a possibility of having uneven thickness in the curved portion.

On the other hand, in the production method of the invention, when the total heating time is controlled to 60% or less of the total arc melting time, excessive heating of the portion extending from the lower part of side wall to the curved portion and the bottom part can be suppressed, while sufficiently heating the rim edge 15, and thus the glass viscosity of this portion is not decreased to a large extent. Thus, an extreme increase in thickness in the corner parts of the curved portion 17 is prevented, and a crucible having excellent formability can be obtained. In addition, in order to suppress unevenness in the thicknesses of various parts, the total heating may be performed for a time corresponding to about 50% of the total arc melting time, and accordingly, it is preferable to perform local heating for a time corresponding to 40 to 50% of the total arc melting time, and total heating for a time corresponding to 50 to 60% of the total arc melting time.

Specifically, in the case of producing a silica crucible having a mouth diameter of 28 to 32 inches and an average thickness of 11 to 16 mm, it is desirable that the electrode 13 is brought near to the rim edge 15 at a temperature of the inner side of the crucible of 1600 to 2500°C and at a total arc melting time of 20 to 40 minutes, and local heating is performed for 10 to 20 minutes starting from the initiation of arc melting, and subsequently total heating is performed for 10 to 20 minutes.

In the production method of the invention, the arc melting for the local heating is performed while maintaining the horizontal distance L2 from the center of the electrode tip to the heated site of the quartz powder molded product 11 to be 5 to 80% of the horizontal distance L1 from the mold center line L to the heated site as shown in FIG 2. If the distance L2 is larger than 80% of the distance L1, the electrode tip is too far from the heated site, and the effect of local heating becomes insufficient. On the other hand, if the distance L2 is smaller than 5% of the distance L1, the electrode tip is too close to the heated site, and thus quartz powder or molten glass may be blown off by the gas stream generated by arc discharge.

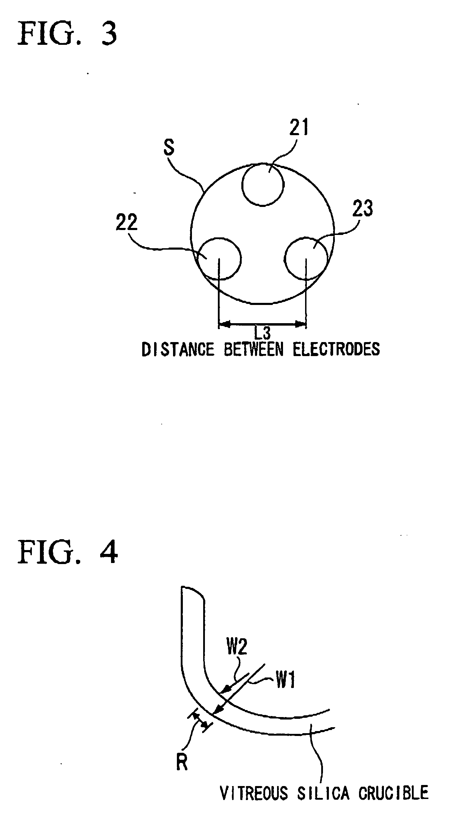

In the case of using a plurality of electrodes, the area of a circumscribed circle S contacting the respective outer circumferences of tips of these electrodes 21, 22 and 23 as shown in FIG. 3 is set to 710 cm² or less, and the entire area of the circumscribed circle S is arc heated. Furthermore, the distance L3 between the electrode centers is set to 15 cm or less. Specifically, under the arc melting conditions exemplified for the local heating, if the area of the circumscribed circle S is larger than the above-mentioned range and the distance L3 between the electrode centers is larger than 15 cm, the heated area becomes too broad, and local heating is not achieved. The mouth diameter of the crucible is larger than the diameter of the circumscribed circle S, and is 3 times or more larger than the diameter of the circumscribed circle S.

According to the production method of the invention, under the arc melting conditions, there can be obtained a vitreous silica crucible in which the curvature W2 of the inner side of the curved portion is 0.8 to 1.2-fold the curvature W1 of the outer side of the curved portion (W2/W1 = 0.8 to 1.2), and five or fewer internal bubbles having a size of 0.5 mm or larger are present in the entire curved portion, within a depth range of 1.0 mm from the inner surface of the whole crucible. Additionally, the curvature W2 of the inner side and the curvature W1 of the outer side of the curved portion are, as shown in FIG 4, the curvatures respectively measured for the inner side and the outer side for a certain measurement range R of the curved portion, and the curvatures W1, W2 may be measured for the entire curved portion every constant range R, and determined based on the average value.

If the curvature W2 of the inner side of the curved portion is out of the range of 0.8 to 1.2-fold the curvature W1 of the outer side of the curved portion, the inhomogeneity of the thickness of the curved portion is increased, and the formability is decreased, thus it not being desirable. Furthermore, if there are more than five internal bubbles having a size of 0.5 mm or larger in the entire curved portion within a depth range of 1.0 mm from the inner surface of the whole crucible, there may be a problem that the internal bubbles expand under high temperature during the use of the crucible, resulting in the peeling of the crucible inner surface and the lowering the yield of silicon single crystals, or the like. Thus, it is not preferable.

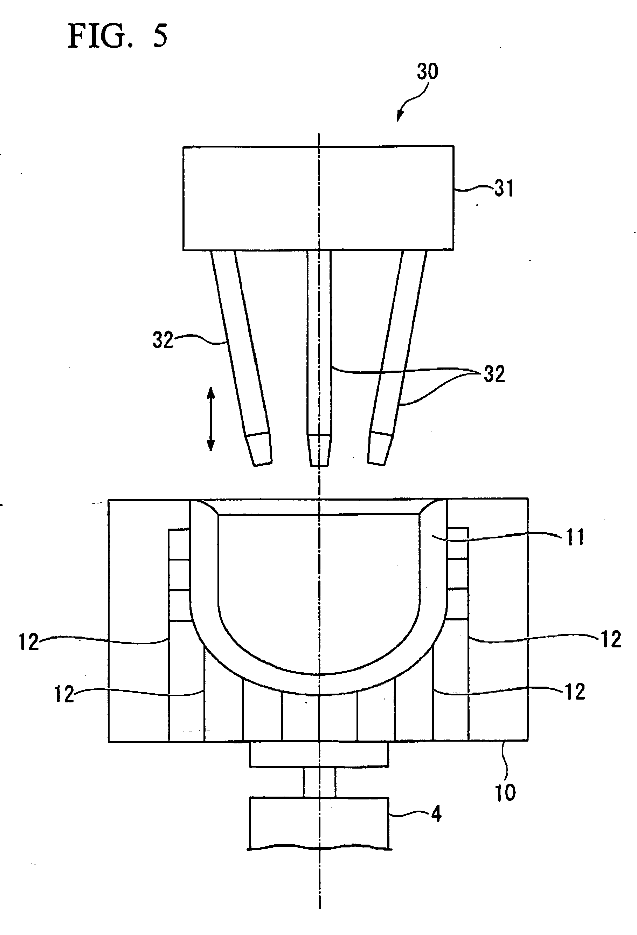

Fig. 5 shows an example of an apparatus for manufacturing a vitreous silica crucible, which is available for the present invention. The apparatus mainly consists of a cylindrical bottom-having shaped mold 10, a movement mechanism 4, which rotates the mold 10 around its axis line, and an arc discharge apparatus 30 for heating the inside of the mold 10. The mold 10 is made of, for example, carbon, and has a lot of vent holes, which are opened to the inside surface of the mold and formed in the mold. Vent holes 12 are connected to a depressurization mechanism (not shown) and the mold 10 can intake air through vent holes from the inside surface while being rotated. A quartz powder molded product can be formed by depositing a quartz powder on the inside surface of the mold 10. The quartz powder molded product is held against the inside wall by centrifugal force due to the rotation of the mold 10. A vitreous silica layer is formed by reducing the pressure through vent holes 12 while heating the held quartz powder molded product 11 by the arc discharge apparatus 30, thereby melting the quartz powder molded product 11. A vitreous silica crucible is manufactured by taking a vitreous silica crucible from the mold 10 and forming the vitreous silica crucible after the cooling. The arc discharge apparatus 30 includes a plurality of carbon electrodes 32, which is formed by high purity carbon and is stick-shaped, an electrodes movement mechanism 31, which holds and moves these carbon electrodes 32, and a power supply apparatus (not shown) for supplying current to each carbon electrode. In this example, there are three the carbon electrodes, but two or more electrodes can be used as long as arc discharge can be carried out between the carbon electrodes 32. The shape of the carbon electrodes is not limited. The carbon electrodes 32 are configured such that electrodes are closer to each other as they are positioned closer to the end. Current can be used whether it is alternate current or direct current. In this embodiment, three electrodes 32 are connected with each phase of a three-phase alternating current. It is preferable that either the mold 10 or the carbon electrodes 32 are provided with a vertically moving means (not depicted), and either the mold 10 or the carbon electrodes 32 are provided with a laterally moving means (not depicted). In the production apparatus , either the rotating mold 10 or the carbon electrodes 32 are moved laterally, and thereby the carbon electrodes 32 are moved relative sideways with respect to the mold center line, and arc melting can be performed at an eccentric position.

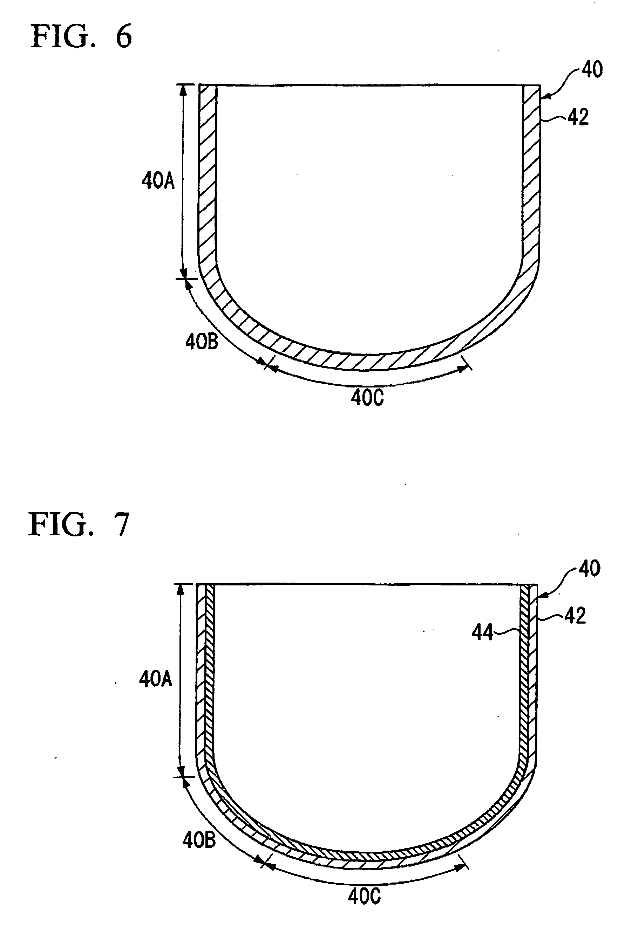

Fig. 6 shows an example of a vitreous silica crucible. The vitreous silica crucible 40 is configured with wall part 40A, curved portion 40B, and bottom part 40C and formed by easy-to-crystallize vitreous silica 42 without addition of crystallization catalyst. The vitreous silica can be formed to be various embodiments. The embodiments are (A) the embodiment, in which a whole (or a part of a) crucible is formed by easy-to-crystallize vitreous silica 42 without the addition of a crystallization catalyst as an embodiment shown in Fig. 6, (B) the embodiment, in which at least a surface layer of a crucible is formed by easy-to-crystallize vitreous silica 42 without the addition of a crystallization catalyst, and (C) the embodiment, in which a wall part 40A, a curved portion 40B, or at least an outside surface of the wall part 40 A of a crucible is formed by easy-to-crystallize vitreous silica 42 without the addition of a crystallization catalyst.

Fig. 7 shows another embodiment of a vitreous silica crucible. The vitreous silica crucible 40 is configured with wall part 40A, curved portion 40B and bottom part 40C. The inside surface layer is formed by synthetic fused silica 44 and the outside surface layer is formed by easy-to-crystallize vitreous silica 42 without the addition of a crystallization catalyst, which is vitrified natural silica. Moreover a vitreous silica crucible can be formed by (D) easy-to-crystallize vitreous silica 42 without the addition of a crystallization catalyst, in which the inside surface layer of the vitreous silica crucible is formed by synthetic fused silica 44 and the outside surface layer of the vitreous silica crucible is formed by vitrified natural silica. Such a vitreous silica crucible is manufactured by deposition of crystalline natural silica powder to the inside surface of the rotation mold, deposition of crystalline synthetic quartz powder thereon (inner side), and heating and melting it at vitrification temperature (in the range of 1710 to 1780°C, preferably in the range of 1730 to 1750°C). Only the outside surface layer of wall part 40A, not the entire area of the outside surface layer of the crucible, may be formed by easy-to-crystallize vitreous silica 42. Because the strength of the wall part 40A is especially significant.

### EXAMPLES

Hereinafter, the present invention will be described with reference to Examples and Comparative Examples.

A vitreous silica crucible having a mouth diameter of 28 inches, a height of 500 mm, and an average wall thickness of 11 mm was produced under the conditions indicated in Table 1, using a synthetic silica powder and/or a natural quartz powder as the raw material and by arc heating the quartz powder at a temperature of the inner side of the crucible of 1600 to 2500°C. For this crucible, the number of internal bubbles in the curved portion, and the ratio of the inner side curvature and the outer side curvature are presented in Table 1, along with the production conditions. The inside surface layer of the vitreous silica crucible may be formed by synthetic fused silica and at least the outside surface layer of the wall part may be formed by vitreous silica of vitrified natural silica. The average particle size of synthetic silica powder is 350 µm and the range thereof is 60-600 µm. The average particle size of natural quartz powder is 250 µm and the range thereof is 50-500 µm.

In Table 1, the proportion of the total heating is the ratio of the total heating relative to the total arc time (%); the distance of the electrode tip is the ratio of the distance L2 from the heated site to the electrode tip relative to the distance L1 from the heated site to the mold center line (L2/L1: %); the ultimate vacuum is the maximum degree of vacuum during the are melting of the quartz powder molded product; the number of bubbles is the number of bubbles which have a size of 0.5 mm or larger, and are included within a depth range of 1.0 mm from the inner surface of the whole crucible; and the ratio of curvature (W2/W1) is the ratio of the inner side curvature W2 of the curved portion and the outer side curvature W1 of the curved portion based on the average value of the measurements made in every constant range over the entire curved portion.

As shown in Table 1, in Examples 1 to 6 of the invention, all had high ultimate vacuum, and thus had small numbers of bubbles. The ratio of curvature was in the range of 0.8 to 1.2, and the formability was good. On the other hand, in Comparative Examples 1 to 5 which are out of the scope of the invention, all had low ultimate vacuum, and the number of bubbles was dramatically high. The ratio of curvature is larger than 1.2, and the formability was poor.

**[Table 1]**

| | Proportion of total heating (%) | Distance of electrode tip (%) | Area of circumscribed circle (cm²) | Distance between electrodes (cm) | Ultimate vacuum (kPa) | Number of bubbles | Ratio of curvature (%) |
|---|---|---|---|---|---|---|---|
| Example 1 | 12 | 30 | 300 | 6 | 65 | 3 | 0.95 |
| Example 2 | 35 | 40 | 500 | 8 | 62 | 2 | 1.03 |
| Example 3 | 53 | 50 | 700 | 9 | 64 | 3 | 1.05 |
| Example 4 | 60 | 10 | 500 | 8 | 65 | 2 | 1.10 |
| Example 5 | 35 | 80 | 500 | 8 | 69 | 4 | 1.02 |
| Example 6 | 35 | 40 | 500 | 15 | 69 | 3 | 1.08 |
| Comp. Ex. 1 | 87 | 40 | 500 | 8 | 45 | 17 | 1.24 |
| Comp. Ex. 2 | 35 | 3 | 500 | 8 | 40 | 15 | 1.26 |
| Comp. Ex. 3 | 35 | 90 | 500 | 8 | 45 | 13 | 1.30 |
| Comp. Ex.4 | 35 | 40 | 900 | 10 | 41 | 14 | 1.25 |
| Comp. Ex. 5 | 35 | 40 | 500 | 20 | 49 | 8 | 1.31 |

Natural quartz is a raw material obtained by digging up raw quartz stone and going through the steps of fracturing, purification, and the like. Natural quartz powder consists of crystals of α-quartz. Natural quartz powder contains 1 ppm or more of Al and Ti. Natural quartz powder also contains a higher level of other metal impurities than synthetic silica powder. Natural quartz powder hardly contains silanol. The silanol amount of glass obtained by fusing natural quartz powder is less than 100 ppm. In the glass obtained by natural quartz powder, when the light transmission rate is measured, transmission rate is drastically decreased when the light wavelength is less than 250 nm because of 1 ppm of Ti mainly contained as a impurity. When the light wavelength is 200 nm, the light is hardly transmitted. An absorption peak is observed near the 245 nm due to oxygen defects. In a fusion product of natural quartz powder, when fluorescence spectra obtained by excitation of ultraviolet ray of wavelength 245 nm are measured, fluorescence peak is observed at 280 nm and 390 nm. These fluorescence peak are due to oxygen bond defects in the glass.

Synthetic silica is a raw material, which is chemically synthesized and manufactured, and synthetic fused silica is amorphous. Because a raw material of synthetic silica is a vapor or a liquid, purification can be done easily, and synthetic silica powder can be of a higher purity than natural powder quartz. Raw materials as a raw material of synthetic fused silica include a raw material originated from vapor material such as carbon tetrachloride and a raw material originated from liquid material such as silicon alkoxide. In synthetic fused silica powder, all impurities can be controlled to be less than 0.1 ppm. In synthetic fused silica powder by a sol-gel method, silanol generated by hydrolysis of alkoxide usually remains in the range of 50-100 ppm. In synthetic fused silica, of which carbon tetrachloride is a raw material, silanol can be controlled to be in a wide range of 0-1000 ppm, but about 100 ppm of chlorine is usually included. When alloxide is a raw material, synthetic fused silica containing no chlorine can be obtained easily. Synthetic fused silica by sol-gel method contains about 50-100 ppm of silanol before fusion as above-described. When vacuum fusion is carried out, desorption of silanol occurs and silanol of vitreous silica obtained is reduced to about 5-30 ppm. In addition, the amount of silanol is different by the fusion conditions such as fusion temperature and elevated temperature. The amount of silanol of a glass obtained by fusing natural quartz powder under the same conditions is less than 5 ppm. In general, the degree of viscosity of synthetic fused silica is lower at a high temperature than that of vitreous silica obtained by fusing natural quartz powder. One reason for is that silanol or halogen cuts the network structure of tetrahedral SiO₄. In a glass obtained by fusing synthetic fused silica powder, when fluorescence spectra obtained by excitation of ultraviolet rays with a wavelength of 245 nm are measured, a fluorescence peak is not observed as a fusion product of natural quartz powder. Whether a glass material is natural quartz or synthetic quartz can be determined by measurement of impurity concentration included, measurement of different amounts of silanol, or measurement of fluorescence spectra obtained by excitation of ultraviolet rays with a wavelength of 245 nm.

## Claims

1. A method for producing a vitreous silica crucible, the method comprising arc melting a quartz powder molde product (11) loaded in a rotating mold (10) while performing vacuum suction, wherein the electrode (19) is moved sideways with respect to the center line of the mold (L) upon the initiation of arc melting or during the arc melting, and the arc melting is performed at an eccentric position, wherein
total heating in which arc melting is performed with the electrode (13) positioned along the center line of the mold (L), and local heating in which arc melting is performed with the electrode (13) positioned at an eccentric position outside the mold center line (L) are carried out;
the total heating time is limited to 60% or less of the total arc melting time;
in the local heating, heating and melting are performed while the distance (L2) from the center of an electrode tip to the heating site of the quartz powder molded product is maintained at 5 to 80% of the distance (L1) from the mold center line to the heating site;
the area of a circumscribed circle contacting a plurality of electrode tips is maintained at 710 cm² or less, and the entire area of the circumscribed circle (5) is arc heated; and
the distance between the electrode centers (L3) is in the range of 2 to 15 cm.

## Patentansprüche

1. Verfahren zur Herstellung eines Quarzglastiegels, umfassend das Lichtbogenschmelzen eines in eine rotierende Form (10) eingesetzten Quarzpulverformlings (11) unter Durchführen einer Vakuumabsaugung, wobei die Elektrode (13) zu Beginn des Lichtbogenschmelzens oder während des Lichtbogenschmelzens seitlich bezüglich der Mittellinie der Form (L) bewegt und das Lichtbogenschmelzen in exzentrischer Stellung durchgeführt wird, wobei
vollständiges Erhitzen durchgeführt wird, bei dem das Lichtbogenschmelzen mit der Elektrode (13) in einer Stellung entlang der Mittellinie der Form (L) erfolgt, und lokales Erhitzen durchgeführt wird, bei dem das Lichtbogenschmelzen mit der Elektrode (13) in einer exzentrischen Stellung außerhalb der Mittellinie der Form (L) erfolgt;
die Zeit des vollständigen Erhitzens auf 60% oder weniger der Gesamtzeit des Lichtbogenschmelzens begrenzt ist;
beim lokalen Erhitzen das Erhitzen und Schmelzen so durchgeführt wird, dass der Abstand (L2) von der Mitte der Elektrodenspitze zur Stelle des Erhitzens des Quarzpulverformfings auf 5 bis 80% des Abstands (L1) von der Mittellinie der Form zur Stelle des Erhitzens gehalten wird;
die Fläche eines umschriebenen Kreises, der mehrere Elektrodenspitzen berührt, auf 710 cm² oder weniger gehalten wird, und die gesamte Fläche des umschriebenen Kreises (S) mittels Lichtbogen erhitzt wird; und
der Abstand zwischen den Elektrodenmittelpunkten (L3) im Bereich von 2 bis 15 cm liegt.

## Revendications

1. Procédé de fabrication d'un creuset en silice vitreuse, le procédé comprenant la fusion à l'arc d'un produit moulé (11) en poudre de quartz chargé dans un moule rotatif (10) en produisant une aspiration, moyennant quoi l'électrode (13) est déplacée latéralement par rapport à la ligne médiane (L) du moule à l'initiation de la fusion par arc ou pendant la fusion par arc, et la fusion à l'arc est réalisée à une position excentrique, dans lequel
un chauffage total est appliqué lorsque la fusion à l'arc est réalisée avec l'électrode (13) positionnée le long de la ligne médiane du moule (L) et un chauffage local est appliqué lorsque la fusion à l'arc est réalisée avec l'électrode (13) positionnée à une position excentrique à l'extérieur de la ligne médiane du moule (L),
le temps de chauffage total est limité à 60 % ou moins du temps total de fusion à l'arc,
dans le chauffage local, le chauffage et la fusion sont exécutés lorsque la distance (L2) du centre d'une pointe d'électrode au site de chauffage du produit moulé de poudre de quartz est maintenue dans une plage correspondant à 5 à 80 % de la distance (L1) de la ligne médiane du moule au site de chauffage,
la surface d'un cercle circonscrit mettant en contact une pluralité de pointes d'électrode est maintenue à 710 cm² ou moins, et la surface entière du cercle circonscrit (S) est chauffée à l'arc, et
la distance entre les centres d'électrode (L3) est comprise entre 2 et 15 cm.
